# EUROPÄISCHE PATENTANMELDUNG

(11) **EP 1 633 178 A1**
(43) Veröffentlichungstag der Anmeldung: **08.03.2006**
(21) Anmeldenummer: 04020916.5
(22) Anmeldetag: 02.09.2004
(51) Int. Cl.: H05K 7/14

(54) **Baugruppenrahmen mit standardkonformer Rückwand und mindestens doppelt breiten Baugruppen**

(71) Anmelder: SIEMENS AKTIENGESELLSCHAFT, 80333 München (DE)
(72) Erfinder: Rau, Martin, Dr., 82049 Pullach (DE)

(57) **Zusammenfassung**

Die Erfindung betrifft eine Vorrichtung zum Einsatz in Baugruppenrahmen mit standardkonformer Rückwand, wobei die standardkonforme Rückwand Cross-Links (110) aufweist, die unmittelbar benachbarte Einbauplätze (102) des Baugruppenrahmens paarweise verbinden. Die Vorrichtung verbindet die vorhandenen Cross-Links (110) so, daß dieser Kommunikationsweg auch für Baugruppen zur Verfügung steht, die mehr als einen Einbauplatz breit sind. Die Vorrichtung zeichnet sich aus durch:
- erste Kontaktierungsmittel, die zumindest mit den Cross-Link-Kontakten eines ersten Einbauplatzpaares (202A) verbindbar sind;
- zweite Kontaktierungsmittel, die zumindest mit den Cross-Link-Kontakten eines zweiten Einbauplatzpaares (202B) verbindbar sind; sowie
- Verbindungsmittel (210), die mit den ersten und zweiten Kontaktierungsmitteln verbunden werden, um einen Cross-Link zwischen einem ersten Einbauplatz des ersten Einbauplatzpaares und einem ersten Einbauplatz des zweiten Einbauplatzpaares zu schaffen;
- wobei die ersten und zweiten Kontaktierungsmittel und die Verbindungsmittel (210) so beschaffen sind, daß sie die Bestückung der jeweils zweiten Einbauplätze der Einbauplatzpaare mit mindestens doppelt breiten Baugruppen ermöglichen.

## Beschreibung

Die Erfindung betrifft eine Vorrichtung, die das Einsetzen mindestens doppelt breiter Baugruppen in Baugruppenrahmen mit standardkonformer (z.B. VME, cPCI, ACTA) Rückwand ermöglicht, wobei jeweils benachbarte der mindestens doppelt breiten Baugruppen mittels vorhandener Cross-Links verbunden werden.

Moderne Telekommunikationsnetze stellen stetig wachsende Anforderungen an die Netzwerkinfrastruktur, die mit herkömmlicher Verkabelung und bekannten konstruktiven Aufbauprinzipien zunehmend schwerer erfüllbar sind. Gefordert werden beispielsweise skalierbare Kapazitäten von bis zu 2,5 Tb/s bei Verfügbarkeiten von bis zu 99.999% und einem gleichzeitigen hohen Grad an Modularität und Konfigurierbarkeit. Die Systeme müssen in der Lage sein, große Pools Digitaler Signalprozessoren, Netzwerk- und anderer Prozessoren sowie Speicher hoher Kapazität aufzunehmen und gleichzeitig geringe Aufbau- und Wartungskosten aufweisen.

Herkömmliche Konstruktionen und Architekturen haben unzureichende Redundanz-Konzepte und weisen Baugruppen auf, die für kommende Anwendungen zu klein sind. Die Verlustleistungsableitung herkömmlicher Architekturen ist unzureichend, und die Rückwände, die der Verbindung der leistungsfähigen Baugruppen dienen sollen, weisen eine mangelnde Kapazität auf.

Daher gibt es Bestrebungen, neue und vielseitigere konstruktive Lösungen vorzusehen, die den besonderen Bedürfnissen von Telekommunikationsanlagen Rechnung tragen. Diese Bestrebungen resultierten in der Schaffung von Standards wie Advanced Telecom Computing Architecture (ATCA). Der ACTA-Standard sieht einen mechanischen Aufbau für größere, hotplug-fähige Baugruppen vor und unterstützt die vollständige Redundanz aller Einheiten. Dabei können pro Baugruppen-Einbauplatz Leistungen von bis zu 200 Watt abgeführt werden.

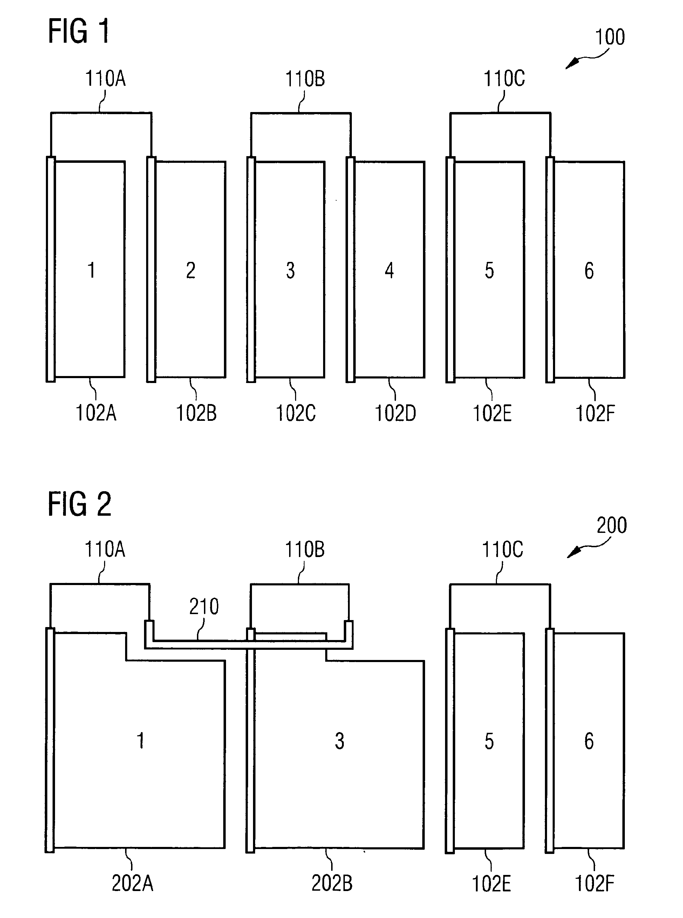

Alle Baugruppen-Einbauplätze, auch "Slots" genannt, weisen dabei eine vorgegebene, einheitliche Breite auf, damit die Bestückung eines Baugruppenrahmens mit funktional verschiedenen Modulen bzw. Baugruppen in beliebigen Kombinationen möglich wird. Für hoch zuverlässige Plattformen, zu denen die Mehrzahl der Telekommunikationsanlagen gehören, sehen die Standards dabei Rückwände vor, die redundante (z.B. mehrfach vorhandene) Baugruppen unterstützen, indem direkte Querverbindungen zwischen den redundanten Modulen vorgesehen sind, die als sogenannte Cross-Links (X-link) in der Verdrahtungs-Rückwand der Baugruppenrahmen realisiert wird. Der ATCA-Standard beispielsweise definiert dafür den sogenannten "Update Channel", der üblicherweise benachbarte Einbauplätze verbindet. Schematisch ist dies in Fig. 1 dargestellt.

Fig. 1 zeigt einen Ausschnitt eines Systems 100 mit standardkonformer Rückwand in schematischer Darstellung. Der dargestellte Ausschnitt umfaßt 6 Einbauplätze 102A-F für Baugruppen einfacher Bauhöhe (die Bauhöhe erstreckt sich dabei in Fig. 1 vom Baugruppenträger eingesetzter Baugruppen nach rechts), wobei jeweils benachbarte Einbauplätze paarweise durch X-Links 110A-C der Rückwand verbunden sind. Im Detail werden ein erster Einbauplatz 102A und ein zweiter Einbauplatz 102B (beziehungsweise die in diese Einbauplätze einsetzbaren Module) durch einen ersten X-Link 110A verbunden, ein dritter Einbauplatz 102C mit einem vierten Einbauplatz 102D durch einen zweiten X-Link 110B und ein fünfter Einbauplatz 102E mit einem sechsten Einbauplatz 102F durch einen dritten X-Link 110C.

Problematischerweise verhindert eine solche standardkonforme Rückwand jedoch den sinnvollen Einsatz redundanter Baugruppen doppelter Breite, d.h. Baugruppen, die zwei Einbauplätze benötigen, weil höhere Bauteile, z.B. Kühlkörper, dies erfordern oder weil die Verlustleistung die pro einfachem Einbauplatz maximal abführbare Verlustleistung übersteigt. Werden solche Baugruppen in einen standardkonformen Rahmen nach Fig. 1 eingesetzt, können die X-Links 110A-C nicht mehr genutzt werden, und die direkte Kommunikation zwischen den redundanten Baugruppen kann nicht erfolgen. Damit ist die System-Redundanz unmöglich.

Es ist daher Aufgabe der vorliegenden Erfindung, eine Vorrichtung anzugeben, die das Einsetzen mindestens doppelt breiter Baugruppen in Baugruppenrahmen mit standardkonformer Rückwand ermöglicht, wobei jeweils benachbarte der mindestens doppelt breiten Baugruppen mittels Cross-Link verbunden werden sollen und wobei die standardkonforme Rückwand lediglich Cross-Links aufweist, die unmittelbar benachbarte Einbauplätze verbinden.

Diese Aufgabe wird gelöst durch eine Vorrichtung zum Einsatz in Baugruppenrahmen mit standardkonformer Rückwand, wobei die standardkonforme Rückwand Cross-Links aufweist, die unmittelbar benachbarte Einbauplätze des Baugruppenrahmens paarweise verbinden. Die Vorrichtung zeichnet sich aus durch:
- erste Kontaktierungsmittel, die zumindest mit den Cross-Link-Kontakten eines ersten Einbauplatzpaares verbindbar sind;
- zweite Kontaktierungsmittel, die zumindest mit den Cross-Link-Kontakten eines zweiten Einbauplatzpaares verbindbar sind; sowie
- Verbindungsmittel, die mit den ersten und zweiten Kontaktierungsmitteln verbunden werden, um einen Cross-Link zwischen einem ersten Einbauplatz des ersten Einbauplatzpaares und einem ersten Einbauplatz des zweiten Einbauplatzpaares zu schaffen;
- wobei die ersten und zweiten Kontaktierungsmittel und die Verbindungsmittel so beschaffen sind, daß sie die Bestückung der jeweils zweiten Einbauplätze der Einbauplatzpaare mit mindestens doppelt breiten Baugruppen ermöglichen.

Die Vorrichtung verbindet vorteilhaft die vorhandenen Cross-Links so, daß dieser Kommunikationsweg auch für Baugruppen zur Verfügung steht, die mehr als einen Einbauplatz breit sind.

Vorteilhafte Ausgestaltungen der erfindungsgemäßen Vorrichtung sind Gegenstand der abhängigen Ansprüche.

Ein besonderer Vorteil der Erfindung ist darin zu sehen, daß es möglich ist, standardkonforme Rückwände auch für breitere redundante Einbauplätze einzusetzen. Die kostenintensive projektspezifische Rückwand-Entwicklung kann somit für diese Anwendungsfälle entfallen. Einmal geschaffene Kontaktierungs- und Verbindungsmittel, beispielsweise Kabelverbindungen, sind universell einsetzbar. Jeder Baugruppen-Einbauplatz kann zu einem beliebig breiten Einbauplatz umgebaut werden. Dabei können auch bereits installierte Systeme einfach und ohne Betriebsunterbrechung mit den erfindungsgemäßen Vorrichtungen nachgerüstet werden, um mittels Cross-Link zu verbindende Baugruppen höherer Breite zu unterstützen.

Im folgenden wird die Erfindung in Ausführungsbeispielen anhand von Zeichnungen näher erläutert. Dabei werden zunächst bevorzugte Ausführungsbeispiele erläutert, bei denen doppelt breite Baugruppen in eine standardkonforme Rückwand eingesetzt werden. Ausführungsbeispiele mit mehr als doppelt breiten Baugruppen werden im Anschluß beschrieben.
Fig. 1 zeigt einen Ausschnitt eines Systems mit standardkonformer Rückwand in schematischer Darstellung, vorbereitet für den Einsatz von Baugruppen einfacher Breite.
Fig. 2 zeigt einen Ausschnitt eines Systems mit standardkonformer Rückwand in schematischer Darstellung, vorbereitet für den Einsatz von Baugruppen doppelter Breite.
Fig. 3A-B zeigen in schematischer Darstellung zwei Ausgestaltungen der Kontaktierungsmittel der erfindungsgemäßen Vorrichtung.
Fig. 4 zeigt in schematischer Darstellung ein Flachbandkabel als Verbindungsmittel zum Einsatz in der erfindungsgemäßen Vorrichtung.

Fig. 1 zeigt, wie bereits erläutert, einen Ausschnitt eines Systems 100 mit standardkonformer Rückwand in schematischer Darstellung. Der dargestellte Ausschnitt umfaßt 6 Einbauplätze 102A-F für Baugruppen einfacher Bauhöhe (die Bauhöhe erstreckt sich dabei in Fig. 1 vom Baugruppenträger eingesetzter Baugruppen nach rechts), wobei jeweils benachbarte Einbauplätze paarweise durch X-Links 110A-C der Rückwand verbunden sind.

Fig. 2 zeigt einen Ausschnitt eines Systems 200, das ebenfalls die standardkonforme Rückwand aus Fig. 1 aufweist. Dabei sind doppelt breite Einbauplätze 202A und 202B geschaffen worden, wobei Einbauplatz 202A einer Zusammenfassung der Einbauplätze 102A und 102B und Einbauplatz 202B einer Zusammenfassung der Einbauplätze 102C und 102D entspricht. In diese doppelt breiten Einbauplätze können beispielsweise redundante Baugruppen doppelter Breite, z.B. Baugruppen mit höheren Bauteile oder mit einer Verlustleistung, welche die pro einfachem Einbauplatz maximal abführbare Verlustleistung übersteigt eingesetzt werden.

Dabei ermöglicht eine durch die erfindungsgemäße Vorrichtung geschaffene Verbindung 210, welche die Cross-Link RückwandSteckverbinder (nicht dargestellt) der Steckplätze 102B und 102D verbindet, daß die vorhandenen Cross-Links 110A-B der standardkonformen Rückwand genutzt werden können, um einen Cross-Link zwischen den doppelt breiten Einbauplätzen 202A und 202B zu schaffen. Dieser Cross-Link wird realisiert mittels des vorhandenen Cross-Link 110A, der erfindungsgemäßen Verbindung 210 zwischen den ursprünglichen Steckplätzen 102B und 102D aus Fig.1 und des vorhandenen Cross-Link 110B.

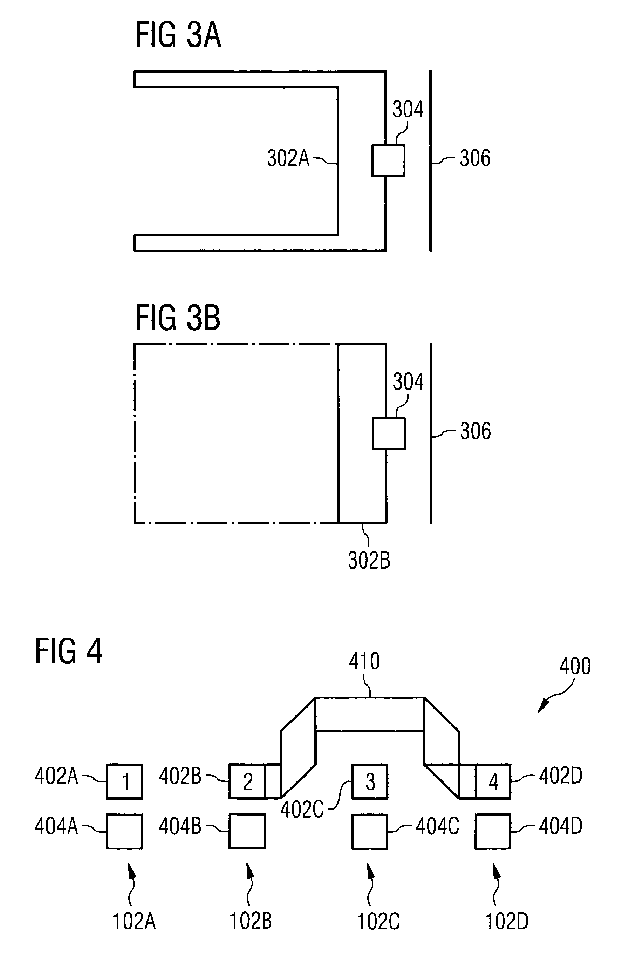

Fig. 3 und 4 zeigen einzelne Elemente der erfindungsgemäßen Vorrichtung in schematischer Darstellung.

Als Kontaktierungsmittel können unbestückte Baugruppenträger vorgesehen werden, die so beschaffen sind, daß sie das Einsetzen von Baugruppen doppelter Breite zulassen und die jeweils in die von den Baugruppen doppelter Breite überdeckten Slots (102B, 102D aus Fig. 1) eingesetzt werden.

Ein erstes Beispiel eines solchen unbestückten Baugruppenträgers 302A zeigt Fig. 3A. Der Baugruppenträger 302A weist einen Stecker 304 zur Verbindung mit dem Rückwand-Steckkontakt auf, der die Leitungen des Cross-Links trägt. Optional können weitere Stecker des Baugruppenträgers 302A mit weiteren Rückwand-Steckkontakten verbunden werden. Die Lage der Rückwand ist durch eine Linie 306 angedeutet. Der Baugruppenträger 302A ist im wesentlichen U-förmig, wobei die Aussparung dem Bereich entspricht, in dem spezifikationsgemäß höhere Bauteile angeordnet werden dürfen. Die verbleibenden oberen und unteren Schenkel dienen der Führung des unbestückten Baugruppenträgers 302A im Slot. Ferner weist der Baugruppenträger Mittel zum Anschluß der Verbindungsmittel auf, beispielsweise Lötpunkte oder Steckverbindermittel oder Sendeempfänger für drahtlose Verbindungen, oder ist mit den Verbindungsmitteln fest verbunden.

Ein zweites Beispiel eines unbestückten Baugruppenträgers 302B zeigt Fig. 3B. Der Baugruppenträger 302B weist einen Stecker 304 zur Verbindung mit dem Rückwand-Steckkontakt auf, der die Leitungen des Cross-Links trägt. Optional können weitere Stecker des Baugruppenträgers 302B mit weiteren Rückwand-Steckkontakten verbunden werden. Die Lage der Rückwand ist wiederum durch Linie 306 angedeutet. Der Baugruppenträger 302B ist im wesentlichen rechteckig und überdeckt im Wesentlichen nur den Steckerbereich eines standardkonformen Baugruppenträgers. Die Dimensionen eines standardkonformen Baugruppenträgers sind zum Vergleich mit gestrichelter Linie angedeutet. So wird gewährleistet, jener Bereich nicht überdeckt wird, in dem spezifikationsgemäß Bauteile angeordnet werden dürfen. Auch Baugruppenträger 302B kann hinsichtlich seiner Höhe so bemessen werden, daß ein Einsetzen in die Führungsschienen eines Baugruppenträgers möglich ist. Der Baugruppenträger 302B weist ebenfalls Mittel zum Anschluß der Verbindungsmittel auf, beispielsweise Lötpunkte oder Steckverbindermittel oder Sendeempfänger für drahtlose Verbindungen, oder ist mit den Verbindungsmitteln fest verbunden. Baugruppenträger gemäß Fig. 3B können zusätzlich durch Schrauben oder Rastvorrichtungen gesichert werden.

Ferner können einfache Stecker zum unmittelbaren Einstecken in die Rückwandsteckverbinder als Kontaktierungsmittel vorgesehen werden, wenn die Steckkräfte allein eine im Sinne der entsprechenden konstruktiven Standards zuverlässige und dauerhafte Verbindung gewährleisten - nicht dargestellt. Solche Stecker können zusätzlich durch Schrauben oder Rastvorrichtungen gesichert werden.

Die Verbindungsmittel können als Kabelverbindung ausgestaltet sein und verbinden mittels der Kontaktierungsmittel zumindest die Cross-Link Rückwandsteckverbinder der überdeckten Einbauplätze 102B und 102D.

Im ATCA-Standard ist eine sogenannte Zone 3 vorgesehen, die für applikationsspezifische Erweiterungen reserviert ist und die der Kabelführung dienen kann. Dabei kann eine applikationsspezifische Rückwand nur für Zone 3 vorgesehen werden. Es ist ferner möglich, Rear Transitioning Modules (RTM) einzusetzen, die über Kabel verbunden werden, oder eine direkte Kabelverbindung kann durch Zone 3 geführt werden.

Ferner kann die Kabelverbindung über Frontblende geführt werden. Insbesondere mit einem u-förmigen unbestückten Baugruppenträgers 302A können an der Frontblende Stecker montiert werden, in die die Kabelverbindung dann eingesteckt wird, um die benachbarten, doppelt breiten Steckplätze zu verbinden.

Fig. 4 zeigt die Verwendung eines Flachbandkabels 410 zur Verbindung der Cross-Link Rückwandsteckkontakte 402B und 402D. Genauer gesagt zeigt Fig. 4 die ersten 4 Einbauplätze 102A-D aus Fig.1. Jeder dieser Einbauplätze weist beispielhaft zwei Rückwandsteckkontakte 402A-D und 404A-D auf. Dabei sei angenommen, daß die Steckkontakte 402 die Cross-Link Leitungen umfassen. Die Steckkontakte 404 hingegen tragen keine mit den Cross-Links assoziierten Leitungen. Das Flachbandkabel 410 kann durch eine Lücke zwischen den einzelnen Steckverbindern 402, 404 hindurch verlegt werden, denn Flachbandkabel können heute in Schichten aus flexiblem Trägermaterial aufgebaut werden. Sie erfüllen damit alle Anforderungen an konstanten Wellenwiderstand und durch vollständige Abschirmung auch an die elektromagnetische Verträglichkeit (Einstrahlung, Abstrahlung). Der ATCA-Standard beispielsweise fordert einen Abstand zwischen Baugruppenträger und Rückwand, durch den ein solches Flachbandkabel geführt werden kann. Notwendig sind lediglich Lücken in der Rückwand-Steckerleiste, wie sie bei der sogenannten Stern-Verkabelung außer am Hub-Steckplatz immer gegeben sind. Das Flachbandkabel kann gefaltet werden; zur Erhöhung der mechanischen Stabilität sind ggf. zusätzliche versteifende Materialien notwendig.

Können keine Flachbandkabel eingesetzt werden oder ist der Abstand zwischen Baugruppenträger und Rückwand zu gering oder nicht vorhanden, können entsprechende Aussparung im Baugruppenträger vorgesehen werden, die dann der Kabeldurchführung dienen - nicht dargestellt. Es können dann auch dickere Kabel zwischen Rückwand und Baugruppenträger geführt werden. Dadurch wird die standard-konforme Anwendung einer solchen Baugruppe in keiner Weise eingeschränkt.

Schließlich ist es möglich, Kabelverbindungen um die oberhalb oder unterhalb der einzusetzenden Baugruppenträger vorzusehen, oder auf die Rückwandsteckkontakte auf der den Baugruppen abgewandten Seite ("Lötseite") der Rückwand zuzugreifen.

Natürlich ist es möglich, die im Zusammenhang mit doppelt breiten Baugruppen erläuterte erfindungsgemäße Vorrichtung auch im Zusammenhang mit Baugruppen größerer Breite anzuwenden - nicht dargestellt. Bei Baugruppen dreifacher Breite würde beispielsweise die erste Baugruppe dreifacher Breite in den Slot 102A der Fig. 1 eingesetzt die Slots 102A-C überdecken, und die zweite Baugruppe dreifacher Breite in den Slot 102D eingesetzt würde die Slots 102D-F überdecken. Zum Schaffen durchgehender Cross-Links sind dann die Cross-Link Rückwandsteckverbinder der Slots 102B und 102C mittels einer erfindungsgemäßen Vorrichtung zu verbinden. Diese kann in diesem Fall aus einer einfachen Kabelverbindung mit geeigneten Steckern bestehen; eine Durchführung durch Baugruppenträger ist nicht notwendig, da sich die Slots 102B und 102C im Überdeckungsgebiet der in Slot 102A eingesetzten Baugruppe befinden.

Folglich ist die Verbindung der Cross-Links für Baugruppen mit dreifacher Breite besonders einfach. Deshalb kann es vorteilhaft sein, Baugruppen mit dreifacher Breite anstelle von Baugruppen zweifacher Breite vorzusehen, weil die Verbindung 210 dadurch besonders einfach und preiswert realisierbar wird.

Das Prinzip läßt sich auch auf noch breitere Baugruppen anwenden, wobei bei allen geradzahligen Breitenfaktoren die Durchführung über den Baugruppen-Einbauplatz erforderlich wird, bei allen ungeradzahligen nicht.

## Patentansprüche

1. Vorrichtung zum Einsatz in Baugruppenrahmen mit standardkonformer Rückwand, wobei die standardkonforme Rückwand Cross-Links (110) aufweist, die unmittelbar benachbarte Einbauplätze (102) des Baugruppenrahmens paarweise verbinden,
**gekennzeichnet durch**
- erste Kontaktierungsmittel, die zumindest mit den Cross-Link-Kontakten eines ersten Einbauplatzpaares (202) verbindbar sind;
- zweite Kontaktierungsmittel, die zumindest mit den Cross-Link-Kontakten eines zweiten Einbauplatzpaares (204) verbindbar sind; sowie
- Verbindungsmittel (210), die mit den ersten und zweiten Kontaktierungsmitteln verbunden werden, um einen Cross-Link zwischen einem ersten Einbauplatz (102B) des ersten Einbauplatzpaares und einem ersten Einbauplatz (102D) des zweiten Einbauplatzpaares zu schaffen;
- wobei die ersten und zweiten Kontaktierungsmittel und die Verbindungsmittel (210) so beschaffen sind, daß sie die Bestückung der jeweils zweiten Einbauplätze (102A, 102C) der Einbauplatzpaare mit mindestens doppelt breiten Baugruppen ermöglichen.

2. Vorrichtung nach Anspruch 1, welche einen Cross-Link zwischen den ersten Einbauplätzen unmittelbar benachbarter Einbauplatzpaare zum Einsetzen doppelt breiten Baugruppen in die jeweils zweiten Einbauplätze der Einbauplatzpaare vorsieht.

3. Vorrichtung nach einem der Ansprüche 1 oder 2, bei der die ersten oder zweiten Kontaktierungsmittel einen Rückwandsteckverbinder (304) umfassen, der zumindest in die Cross-Link-Kontakte der Rückwand einsteckbar ist.

4. Vorrichtung nach einem der Ansprüche 1 bis 3, bei der die ersten oder zweiten Kontaktierungsmittel ein kurzes Trägermodul (302B) umfassen, dessen Abmessungen so bemessen sind, daß das kurze Trägermodul Bauelemente einer in einem benachbarten Einbauplatz eingebrachten breiten Baugruppe nicht behindert.

5. Vorrichtung nach einem der Ansprüche 1 bis 3, bei der die ersten oder zweiten Kontaktierungsmittel ein Trägermodul (302A) umfassen, dessen äußere Abmessungen den für den Baugruppenrahmen geltenden Standardabmessungen entspricht, wobei das Trägermodul ferner eine Aussparung aufweist, die so bemessen sind, daß das kurze Trägermodul Bauelemente einer in einem unmittelbar benachbarten Einbauplatz eingebrachten breiten Baugruppe nicht behindert.

6. Vorrichtung nach einem der Ansprüche 1 bis 5, bei der die Verbindungsmittel (210) ein Flachbandkabel (410) umfassen, das an der einschubseitigen Seite der Rückwand entlang in Zwischenräumen zwischen Kontakten oder Kontaktgruppen (402, 404) der Rückwand verlegt ist.

7. Vorrichtung nach einem der Ansprüche 1 bis 5, bei der die Verbindungsmittel (210) ein Kabel umfassen, das mit frontblendenseitigen Anschlüssen der ersten und zweiten Kontaktierungsmittel verbunden ist.

8. Vorrichtung nach einem der Ansprüche 1 bis 5 zum Einsatz in einen Baugruppenrahmen mit Rückwand nach dem ATCA-Standard, bei der die Verbindungsmittel (210) ein Kabel umfassen, das in der Zone 3 der Rückwand geführt wird.
